**Europäisches Patentamt**

**European Patent Office**

**Office européen des brevets**

(11) Publication number : **0 471 628 A1**

# EUROPEAN PATENT APPLICATION

(21) Application number : **91420089.4**

(22) Date of filing : **19.03.91**

(51) Int. Cl.[5] : **H01L 21/033, H01L 21/84, H01L 21/027**

(30) Priority : **09.08.90 JP 212324/90**

(43) Date of publication of application :
**19.02.92 Bulletin 92/08**

(84) Designated Contracting States :
**DE FR GB NL**

(71) Applicant : **GTC CORPORATION**
**1-6-5 Higashi Nihonbashi**
**Chuo-ku, Tokyo (JP)**

(72) Inventor : **Nagae, Yoshiharu**
**c/o GTC Corporation, 1-6-5,**
**Higashi-Nihonbashi**
**Chuo-ku, Tokyo (JP)**
Inventor : **Saito, Takeshi**
**c/o GTC Corporation, 1-6-5,**
**Higashi-Nihonbashi**
**Chuo-ku, Tokyo (JP)**
Inventor : **Okazaki, Satoshi**
**c/o GTC Corporation, 1-6-5,**
**Higashi-Nihonbashi**
**Chuo-ku, Tokyo (JP)**
Inventor : **Akimoto, Yasumasa**
**c/o GTC Corporation, 1-6-5,**
**Higashi-Nihonbashi**
**Chuo-ku, Tokyo (JP)**
Inventor : **Kitamura, Teruo**
**c/o GTC Corporation, 1-6-5,**
**Higashi-Nihonbashi**
**Chuo-ku, Tokyo (JP)**
Inventor : **Mori, Yuji**
**c/o GTC Corporation, 1-6-5,**
**Higashi-Nihonbashi**
**Chuo-ku, Tokyo (JP)**

Inventor : **Mikami, Yoshiro**
**c/o GTC Corporation, 1-6-5,**
**Higashi-Nihonbashi**
**Chuo-ku, Tokyo (JP)**
Inventor : **Kuwabara, Kazuhiro**
**c/o GTC Corporation, 1-6-5,**
**Higashi-Nihonbashi**
**Chuo-ku, Tokyo (JP)**
Inventor : **Hayama, Hiroshi**
**c/o GTC Corporation, 1-6-5,**
**Higashi-Nihonbashi**
**Chuo-ku, Tokyo (JP)**
Inventor : **Asada, Hideki**
**c/o GTC Corporation, 1-6-5,**
**Higashi-Nihonbashi**
**Chuo-ku, Tokyo (JP)**
Inventor : **Asaka, Kenji**
**c/o GTC Corporation, 1-6-5,**
**Higashi-Nihonbashi**
**Chuo-ku, Tokyo (JP)**
Inventor : **Nakamura, Kazunori**
**c/o GTC Corporation, 1-6-5,**
**Higashi-Nihonbashi**
**Chuo-ku, Tokyo (JP)**
Inventor : **Kubozono, Kenichi**
**c/o GTC Corporation, 1-6-5,**
**Higashi-Nihonbashi**
**Chuo-ku, Tokyo (JP)**
Inventor : **Kobayashi, Masayoshi**
**c/o GTC Corporation, 1-6-5,**
**Higashi-Nihonbashi**
**Chuo-ku, Tokyo (JP)**
Inventor : **Kaneko, Eiji**
**c/o GTC Corporation, 1-6-5,**
**Higashi-Nihonbashi**
**Chuo-ku, Tokyo (JP)**

(74) Representative : **Laurent, Michel et al**
**Cabinet LAURENT et CHARRAS, 20, rue Louis**
**Chirpaz B.P. 32**
**F-69131 Ecully Cedex (FR)**

(54) **Thin film transistor circuit and its manufacturing.**

(57) A method of making a thin film transistor circuit wherein the method includes at least one step of a printing process for preparing ink patterns to define the area to be affected by the application of an etching process.
The invention relates also to a thin film transistor circuit obtained accordingly.

# FIG.1

(a)

(b)

(c)

(d)

(e)

Field of the Invention

This invention relates to a method of manufacturing extensive thin film transistor circuits on a large piece of glass plate and to the circuits made by the process.

Background of the Invention

There are a variety of known methods for driving liquid crystal display elements, but in recent years, a method called active matrix method has been gaining attention. This method utilizes a glass plate (base) on which to fabricate thin film transistor circuits containing a matrix of non-linear devices (such as diodes) and switching devices (such as transistors) to operate display devices such as liquid crystal displays which consist of numerous picture elements.

This type of technology is explained in detail in "Liquid Crystal Television Display: Principles and Applications of Liquid Crystals" (KTK Scientific Publishers, Chapter 7, pp211-277, 1987).

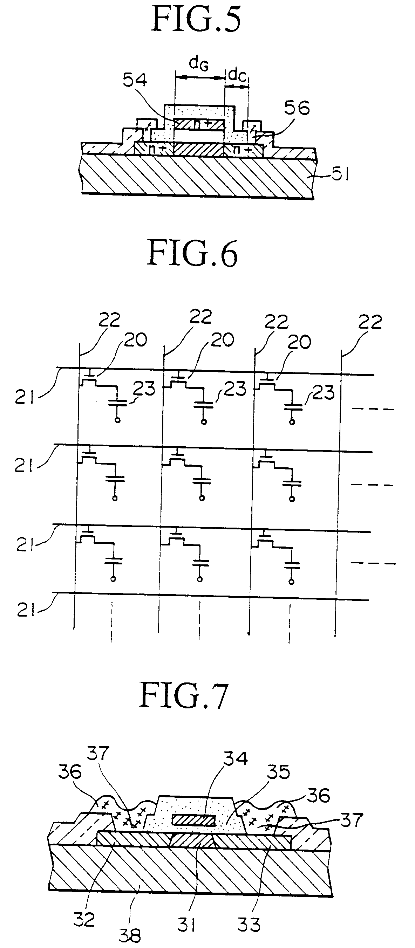

Figure 6 is an equivalent circuit of active matrix driven liquid crystal display system, using thin film transistor 20 as the switching device. Figure 6 shows a picture element (hereinafter referred to as a pixel), to consist of a liquid crystal cell 23 and a thin film transistor 20 which drives the cell, it also shows that the pixel is electrically connected in a matrix to a scanning line 21 and a signal line 22.

Figure 7 shows an example of a thin film transistor architecture. It comprises a polysilicon layer 31, a source 32, a drain 33, a gate 34, gate insulation 35, metal electrodes 36 for wiring contact, access holes 37 for wiring connections, a glass base 38. Wiring connections from the metal electrodes 36 are made to appropriate scanning lines 21 and signal lines 22 as shown in Figure 6.

Small-screen TVs and I/O devices for office automation equipment require active matrix-driven display equipment having pixel sizes as small as several tens of micro meters square, creating a need for fine transistor circuit sizes in the range of several to several tens of micro meters.

Such fine patterns are presently produced by a photolithography method involving photomask pattern exposure to a source of light. This method utilizes mirror-projection or step-and-repeat exposure techniques on a photographic glass plate of about 300-400 mm square. The technique is capable of producing a resolution of 3-4 $\mu$m, an alignment precision of $\pm 1$ $\mu$m, and a processing throughput speed of several minutes per one glass plate.

In recent years, demands have been increasing for realization of meter-sized screens, coming mainly from high capacity, large screen display panel typified by HDTVs. In order to achieve such a technology, it is necessary for the matrix to drive over one thousand lines of both scanning lines 21 and signal lines 22, shown in Figure 6, connected to over several million pixels. Commercial production of such a display screen would have to provide a highly advanced technology of microcircuit printing technique, able to resolve several micrometers to several tens of micrometers of pixels on a glass plate of over one meter size and having a throughput speed of several million transistors.

However, the existing capability of photo-exposure equipment is limited to about 100 150 mm square of exposure area at one time because of the limitations in the resolving power of the present light optical system. To prepare large size screens by this technique requires exposures of small area at a time to be repeated over the large glass surface. Consequently, it requires highly accurate alignment.

In practice, preparation of micro-patterns on a meter sized screen requires dividing the picture area into about one hundred units, and repeating the process of moving, stopping and exposing at each unit area. Consequently, the throughput speed per glass base becomes several tens of minutes per cycle. This is a serious barrier to realization of a commercial large screen display technology and the development of efficient production technology.

Further, such a procedure calls for precision alignment at each exposure, which needs to be maintained over the entire large area. It is extremely difficult to hold an alignment precision of $\pm 1$ $\mu$m over a meter sized screen, and the consequent imaging defects produced by misalignment have been a serious deficiency of the existing technology of producing large screen displays.

Summary of the present Invention

The purpose of the present invention is to present a cost-efficient production method of making micro-patterns of thin film transistor matrix circuits on a meter-sized glass plate.

The present invention presents a method of making thin film transistor circuits involving at least one printing of ink patterns for use in subsequent etching.

Another aspect of this invention presents a method of printing micro-circuit patterns on the surface of photo-resist film laid on a surface to be etched (hereinafter referred to as the etch removal surface or area).

Still another aspect of this invention presents a method of printing micro-circuit patterns on the surface of negative-type photo-resist film, when the area to be fabricated (hereinafter referred as fabrication area) is less than the etch removal area.

Further aspect of this invention presents a thin film transistor circuit wherein the minimum fabricable dimension is represented by the length of the gate element, and wherein the distance between the access hole and the gate element is not less than the limit of alignment precision.

An aspect of this invention is to produce a large area ink pattern in one printing, thus achieving cost-effective production of active-matrix driven large screen display panel. Further, by precoating the base with the photo-resist material used in conventional method of photolithography, it is possible to prevent contaminating semiconductor or metallic thin films with impurities from the printing ink. Further, in a staggered transistor architecture, the adoption of the gate length as the smallest fabricable dimension achievable by this printing method, when combined with the ion implantation technique, minimizes the formation of potential parasitic material around each transistor element, thereby providing a large screen display panel having high speed response capability.

Further, the adoption of the separation distance between the access hole and the gate element to be not less than the limit of alignment precision prevents shorting of metal electrodes with the gate element, thus minimizing imaging defects to provide a large screen display panel of high picture quality.

In a summarizing aspect of this invention, the invented method permits efficient production of a plurality of matrix circuits on a large area base, consisting of thin film transistors having high response speed and low defect density. Accordingly, the invented method allows cost-effective production of large screen display devices made of an active-matrix driven liquid crystal panel.

Thin film transistor circuits referred to in this invention comprise a base material such as glass, thin film transistors fabricated thereon, scanning lines and signal lines electrically connected to appropriate circuit elements, such as electrodes, condensers and resistors.

## Brief Description of Drawings

Figure 1 is a schematic drawing illustrating the basic processing steps of the invented printing process.

Figure 2 is an oblique view of an example of the manufacturing process.

Figure 3 is a schematic drawing illustrating the steps of forming a transistor architecture.

Figure 4 is a schematic drawing illustrating another processing steps of the manufacturing process.

Figure 5 is a cross sectional view illustrating the architectural elements of an example device.

Figure 6 is an equivalent circuit of an active matrix driven liquid crystal display circuit made of thin film transistor elements.

Figure 7 is a cross sectional view illustrating the architectural elements of an example thin film device made by the method of the present invention.

## Detailed Description of the Preferred Embodiments

### Preferred Embodiment No.1

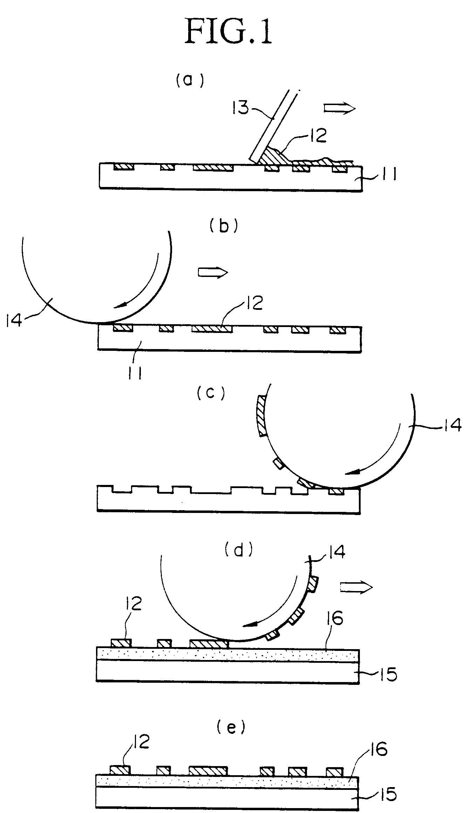

Figure 1 illustrates a first preferred embodiment of this invention. This is an example of utilizing the intaglio method of printing. An intaglio plate 11 containing the patterns is produced by etching away the patterns, for example, to form grooves which are to be filled with printing ink. After filling the grooves with ink, the excess ink is wiped away with a doctor blade 13, as illustrated in Figure 1 (a). Next, the transfer roll 14 is rolled across the intaglio plate 11 as shown in Figure 1 (b), by which action the patterns on the plate 11 are transferred to the transfer roll 14 as illustrated in Figure 1 (c). The transfer roll 14 is rolled as shown in Figure 1 (d) over the surface of a base 15, which has a fabricating film layer 16 made of Si, Al or $SiO_2$, during which time the ink patterns on the transfer roll 14 are transferred again onto the surface of fabricating film layer 16 as illustrated in Figure 1 (e). The fabricating film layer 16 is subjected to either wet or dry etching to fabricate the appropriate patterns on the base. By following the steps as illustrated in these figures, it is possible to cost-effectively produce circuit elements for driving large screen display devices.

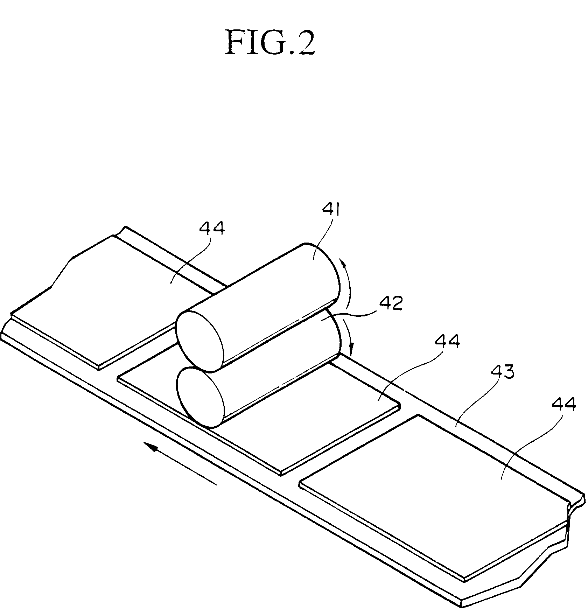

The production line shown in Figure 2 consists of a plate cylinder 41, a transfer cylinder 42, a constant speed belt 43 which transports glass bases 44 at suitable intervals so as to produce patterned glass plates on a continuous basis.

The printing ink used here is of the type to withstand etching attachs, but it is equally important that the ink be free of impurities which may contaminate the fabricating film layer 16.

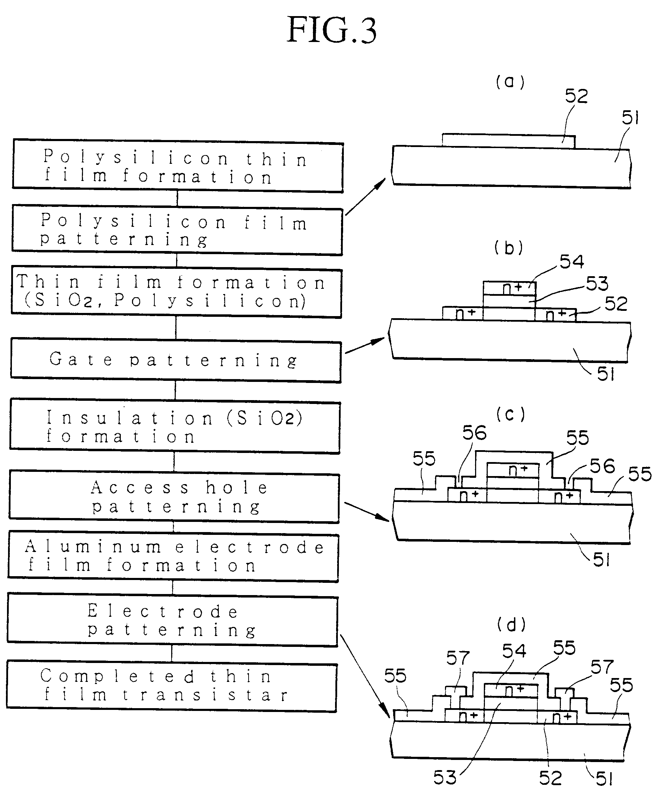

The above case provided an example of a single-step processing of circuit patterns by etching process, but typical thin film device circuits require from four to upper teens processing steps. For example, to make the architecture shown in Figure 3 (d), it is necessary tocarry out four patterning steps as shown in Figure 3 flow sheet. First, a layer of polysilicon 52 is deposited to a thickness of about 0.1 μm on the surface of a glass base 51.

The first patterning is carried out at this stage to define the outer boundary of the circuit by using the invented process. Figure 3 (a) shows the completion of this stage. Next two deposition steps are carried out in succession, consisting of a 0.1 μm layer of $SiO_2$ for gate insulation 53, followed by a 0.1 μm layer of polysilicon for gate electrodes 54. Patterning step No. 2, according to the invented printing process, is carried out at this stage as shown in Figure 3 (b), followed by ion implantation to produce $n^+$ regions. The surface is covered with an insulation layer 55 composed of $SiO^2$ of about 0.3 μm thickness. Patterning step No. 3, shown in Figure 3 (c), involves printing of access hole 56 patterns for accessing source and drain contact wires. The final patterning step No. 4 and the printing of electrode 56 patterns complete the process to produce the final configuration of a transistor architecture shown in Figure 3 (d).

Further processing involves depositing of a transparent electrode film, such as indium tin oxide (ITO) on the device surface, and such a coated glass base combined with an opposing glass plate equipped with color filters completes a large screen display device. Finally, the thin space between the two plates is filled with liquid crystal to produce a large area liquid crystal display panel.

Preferred Embodiment No. 2.

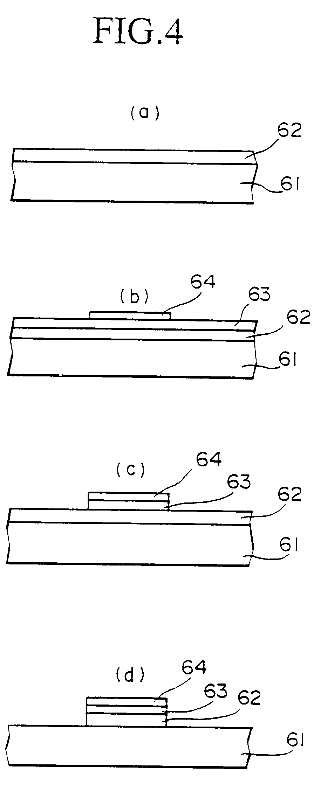

This case is an example of applying a coating of photo-resist film on the fabricating film layer before the process of pattern printing. The processing steps are explained in reference to Figure 4.

Figure 4 (a) shows a glass base 61 having a top fabricating film layer of polysilicon 62 of about 0.1 $\mu$m thickness. A 1 $\mu$m thickness film 63 is formed on the top surface of the layer with a positive type photo-resist (OFPR-800 30 CP, Tokyo Ooka).

Pattern printing is carried out as described in Preferred Embodiment No. 1 using an ink 64. This ink is a special purpose ink composed of carbon black blended in a melamin-base thermosetting resin having UV blocking ability. This intermediate stage of processing is shown in Figure 4 (b).

The printed surface is exposed to UV radiation from an ultra-high pressure Hg lamp, and is photographically developed to produce a structure shown in Figure 4 (c).

The next processing step consists of dry gas etching, with $CF_4$ containing 3% $O_2$, to remove the ink layer 64, the photo-resist layer 63 and the polysilicon layer 62 to obtain the completed architecture shown in Figure 4 (d).

The type of steps described above may be repeated several times according to the procedure described in Preferred Embodiment No. 1 to produce any desired architecture.

Further, there are two types of photo-resist materials available commercially: positive and negative types. It is preferable to use the negative type when the ratio of the fabrication area to the overall etch removal area is extremely small, for example, if the overall etch removal area is taken as 100, the fabrication area is 20 or preferably not more than 10, in other word, the percentage of the fabrication area is not more than 20% and preferably not more than 10% of the etch removal area. This choice is made to lessen the generation of processing defects.

The inventors have confirmed through the performance of thin film transistor devices that high quality thin film transistors, having the minimum width separation capability of 10 $\mu$m, can be produced by using the invented printing process.

In this case, since the printing ink does not touch the active component layers directly, there is no danger of contaminating the active component layers.

Preferred Embodiment No. 3

This is a case of utilizing screening printing. The polysilicon layer on top of the glass base was coated with a positive type photo-resist solution (MP1400) available from Shipley Co. by means of a spin coater. After prebaking (90°C, 30 min), the film thickness was 0.9 $\mu$m. The printing screen was a metallized screen, made by Rihneke Co. Model 230-85B), on which was printed the required circuit pattern. The stencil was made of a nickel foil of 5 $\mu$m thickness, which was etched to produce openings corresponding to a positive copy of the desired circuit pattern. The etched nickel foil was attached to a strip material by bonding to form a stencil mesh with an intervening polyester mesh. This screen is known as a combination type suspended metal screen.

The printing machine was Newlong Co. Model 15GT, and the printing ink was Toyo Ink Co Solderex K-1000. The printing conditions were: printing speed 300 mm/s, air pressure of 3.3 Kg/cm$^2$, the distance of 1.8 mm between the strip and the printing surface, hardness of squeegee 75 and its application angle 75°. After the drying process, printing was carried out using the above conditions, and the printed base was exposed to UV radiation, developed and washed to dissolve unexposed ink. The final step in a patterning cycle was post baking at 50°C for 20 min.

The patterning of polysilicon layer is completed when the etching step has been carried out on the patterned photo-resist surface. Repeating this cycle of steps using a number of different patterns results in the production of a desired device architecture as described in the preferred embodiments.

Compared with the depressed surface offset printing process, screen printing process generates distinctively lesser number of pinhole defects in the photo-resist patterns. However, the depressed surface offset printing process is experimentally proven to be superior in the accuracy of pattern reproduction.

Preferred Embodiment No. 4

This case describes the thin film circuits produced by the above described screen printing process. In general, the line width achievable by printing patterning process is necessarily broader than that achievable by conventional photolithography. For example, the minimum line width achievable by the depressed surface offset printing process has been determined by the inventors to be around 10 $\mu$m. Further, the alignment precision is correspondingly less in this printing process as compared with the traditional photolithography method. For example, according to inventors' tests, the alignment precision was around 20 μm. These deficiencies were corrected by devising an appropriate structural layout which compensated for these deficiencies to provide excellent device performance.

In Figure 5 is shown a circuit which is the same as that shown earlier in Figure 3 (d). In Figure 5, the gate length is denoted by $d_G$ and the separation distance between the gate and the access hole is denoted by $d_C$. The inventors have designed this structure according to the maximum achievable resolution of 10 μm, and in combination with ion implantation method for fabricating the source and drain structures, it was possible to minimize the formation of parasitic electrostatic capacitance. The inventors were also able to prevent shorting between the wiring electrodes by choosing the distance $d_C$ to equal the maximum aligning accuracy which was 20 μm.

By choosing the structural layout as shown, it becomes possible to realize meter sized liquid crystal display panels made of defect-free thin film transistorized circuit.

**Claims**

1. A method of making a thin film transistor circuit wherein the method includes at least one step of a printing process for preparing ink patterns to define the area to be affected by the application of an etching process

2. The method of making a thin film transistor circuit according to Claim 1, wherein said printing process is carried out on a film of photo-resistive material applied on the surface to be etched.

3. The method of making a thin film transistor circuit according to Claim 2, wherein said printing process is carried out in conjunction with a negative-type photomask in a case wherein the area to be affected by etching is larger than the area unaffected.

4. The method of making a thin film transistor circuit according to one of Claims 1 and 3, wherein said printing process is an depressed surface offset printing method.

5. The method of making a thin film transistor circuit according to one of Claims 1 and 3, wherein said printing process is a screen printing method.

6. A thin film transistor circuit wherein the minimum gate length is equal to a smallest dimension achievable by a screen offset printing technique, and wherein the smallest separation distance between two access holes is not less than the alignment capability achievable by said screen printing technique.

7. A thin film transistor circuit according to Claim 6, wherein said gate dimension is approximately 10 μm and said separation distance between two access holes is not less than 20 μm.

# FIG.1

(a)

(b)

(c)

(d)

(e)

EP 0 471 628 A1

# FIG.2

8

# FIG.3

(a)

| Polysilicon thin film formation |

| Polysilicon film patterning |

| Thin film formation (SiO2, Polysilicon) |

(b)

| Gate patterning |

| Insulation (SiO2) formation |

(c)

| Access hole patterning |

| Aluminum electrode film formation |

| Electrode patterning |

(d)

| Completed thin film transistar |

# FIG.4

(a)

62
61

(b) 64 63
62
61

(c) 64 63 62
61

(d) 64 63 62
61

# FIG.5

# FIG.6

# FIG.7

**EP 0 471 628 A1**

European Patent Office

## EUROPEAN SEARCH REPORT

Application Number

EP    91 42 0089

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN vol. 14, no. 166 (E-911)30 March 1990 & JP-A-02 021 612 ( HITACHI ) 24 January  1990 | 1,2,5 | H01L21/033 H01L21/84 H01L21/027 |
| Y | * abstract * --- | 4 | |
| Y | EP-A-0 365 169 (MOLEX) * column 4, line 11 - column 5, line 51 * --- | 4 | |
| P,X | EP-A-0 402 942 (DAI NIPPON INSATSU K. K.) * claims; figures * --- | 1-3 | |
| A | EP-A-0 193 820 (KANEGAFUCHI KAGAKU KOGYO K. K.) * claims 1,2,4,8 * --- | 1 | |
| A | US-A-3 564 135 (RCA CORP.) * column 3, line 12 - column 3, line 14; figure 1 * ----- | 1 | |
| | | | **TECHNICAL FIELDS SEARCHED (Int. Cl.5 )** H01L H05K |

The present search report has been drawn up for all claims

| Place of search | Date of completion of the search | Examiner |
|---|---|---|
| THE HAGUE | 25 NOVEMBER 1991 | GORI  P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)